# EUROPEAN PATENT APPLICATION

(11) **EP 4 542 657 A1**
(43) Date of publication of application: **23.04.2025**
(21) Application number: 24464003.3
(22) Date of filing: 15.04.2024
(51) Int. Cl.: H01L 31/052, F28D 9/00, F28D 9/04

(54) **HYBRID SYSTEM FOR IMPROVING THE ENERGY EFFICIENCY OF PHOTOVOLTAIC PANELS**

(30) Priority: 18.10.2023 RO 202300576
(71) Applicant: Stefan cel Mare University of Suceava, 720229 Suceava, County Suceava (RO)
(72) Inventor: MILICI, Dan Laurentiu, Suceava (RO); PAVAL, Mihaela, Pojorata, Suceava (RO); ATANASOAE, Pavel, Scheia, Suceava (RO); NITAN, Ilie, Ilisesti, Suceava (RO); UNGUREANU, Constantin, Suceava (RO); IVAROSCHI, Eugen, Curtesti, Botosani (RO); ALISAVETEI, Irina, Manastirea Humorului, Suceava (RO); TUDURIU, Constantin Cornel, 28320 Pinto, Madrid (ES)

(57) **Abstract**

Hybrid system for improving the energy efficiency of photovoltaic panels, according to the invention, consists of a panel placed on the back of the photovoltaic panel and which has a system of channels, of variable section through which the cooling fluid circulates, which can be water for the preparation of hot water or air for heating an enclosure, a channel system that ensures the entry of the cooling fluid through the area in the center of the panel (1), the area with the highest temperature, and its evacuation through the area in the corner of the panel (2), the least warm area.

The summary of the invention will be published together with figure 3.

## Description

The invention relates to a system for improving the efficiency of photovoltaic panels by cooling them in such a way as to improve their efficiency and to obtain in addition to an increase in the electricity produced, domestic hot water or hot air, based on a new channel geometry of cooling placed on the states of the photovoltaic panel.

In order to increase the efficiency of photovoltaic panels, a solution is known (KR20230124224) which mainly consists of a device that generates hot water and electricity based on solar energy and which consists of an assembly of interconnected photovoltaic cells and a serpentine water pipe.

The disadvantages of the described solution consist in the fact that the water pipe is placed in the form of a serpentine without taking into account the temperature distribution on the surface of the panel, which does not allow optimal heat transfer to the liquid in the pipe.

The invention mainly solves the technical problem by allowing an optimal heat transfer between the surface of the panel exposed to sunlight and the cooling fluid passing through the channels behind it through a specific geometry of these channels.

The hybrid system for improving the energy efficiency of photovoltaic panels, according to the invention, removes the disadvantages and problems presented, in that it mainly involves a system of channels starting from the hottest area of the panel, through which the cooling fluid circulates, channels of whose section increases up to the fluid outlet area which is found in the least warm area of the photovoltaic panel.

The invention presents the following advantages:
- Increasing the efficiency of photovoltaic panels by cooling them with fluid knowing that the efficiency of the panels increases with the decrease of their temperature.
- Simultaneous generation of electricity and domestic hot water or hot air. The electricity produced by the solar panels can power electrical appliances, and the heat from the cooling fluid can be used to heat water or heat indoor spaces.
- Energy stability due to the fact that the proposed system can provide electricity and thermal energy even in conditions of interruption of electricity supply from the grid (energy independence in case of problems with the grid or calamities).
- Improved thermal comfort by using solar heat to heat water and/or spaces without relying excessively on traditional heating or air conditioning systems, reducing the carbon footprint by reducing pollution and conserving natural resources.

An example of an embodiment of the invention is given below in connection with the figures:

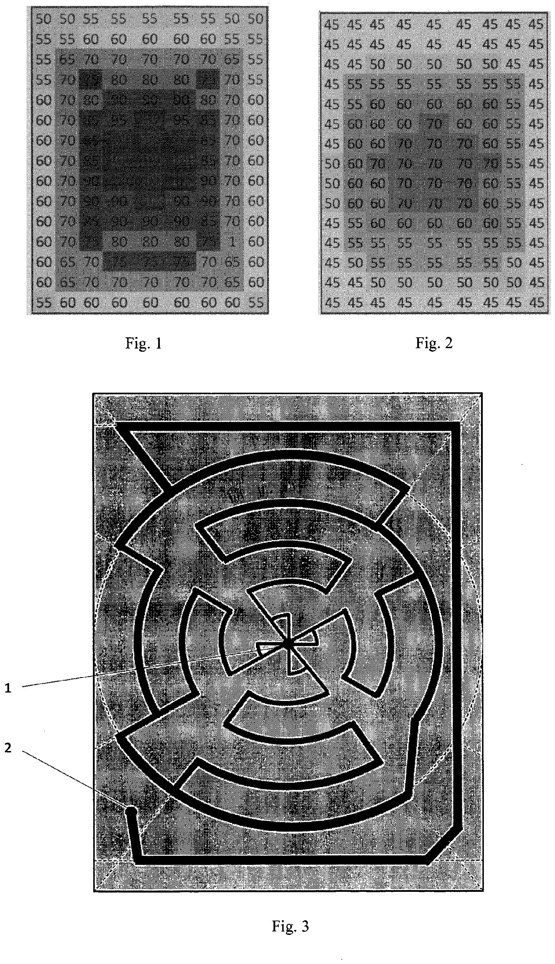

- Fig. 1 - The distribution, in percentages of the maximum temperature, of the temperatures on the surface of a photovoltaic panel with an amorphous layer, on a sunny day, the panel being placed with its bottom side on the ground, at an angle of 45 degrees to the horizontal plane , oriented to the south, at the moment of maximum incidence of the sun's rays on its surface.
- Fig. 2 - The distribution, in percentages compared to the maximum temperature, of the temperatures on the surface of a photovoltaic panel to which the hybrid system was attached to improve the energy efficiency of the photovoltaic panels, the panel being positioned in the same conditions as in fig. 1.
- Fig. 3 - The plastic material panel on which a channel structure according to the invention has been milled and which is placed on the back of the photovoltaic panel to ensure its cooling and obtain the thermal agent for heating.

Hybrid system for improving the energy efficiency of photovoltaic panels, it is mainly characterized by the fact that it consists a plastic material panel, according to figure 3, placed on the back of the photovoltaic panel and which has a system of channels, of variable section through which the cooling fluid circulates, which can be water for the preparation of hot water or air for heating a room, a system of channels that ensures the entry of the cooling fluid through the area in the center of the panel (1), the area with the highest temperature, and its evacuation through the area from the corner of the panel (2), the least warm area.

Because the electricity production efficiency of a photovoltaic panel decreases as its temperature increases due to exposure to solar radiation and because the area that heats up the most is in the center of the panel (Fig. 1), the edges being at a lower temperature than the central area, in the hybrid system for improving the energy efficiency of photovoltaic panels, according to the invention (Fig. 3), the cooling fluid enters the channel system placed behind the photovoltaic panel in its center area (1) where an important heat exchange takes place due to large temperature differences between the cooling fluid temperature and the temperature of the photovoltaic panel, after which the cooling fluid is directed through radial and concentric channels over the entire surface of the panel, the fluid is heated due to the continuous heat exchange with the panel, the section of the channels gradually increasing as the fluid moves away from the center of the panel, which causes a decrease of the fluid speed through the channel, a fact that facilitates the transfer of heat to the cooling fluid even if its temperature gradually increases, obtaining a cooling of the entire surface of the photovoltaic panel (Fig. 2) and a heating of the cooling fluid, due to the optimization of the heat transfer through the geometry of the channels.

The hybrid system for improving the energy efficiency of photovoltaic panels, according to the invention, can be reproduced with the same performance and characteristics whenever necessary, for any application compatible with it or parts of it, a fact that constitutes an argument in favor of complying with the industrial applicability criterion.

## Claims

1. Hybrid system for improving the energy efficiency of photovoltaic panels, **characterized by** the fact that it consists of a panel made of plastic material, placed on the back of the photovoltaic panel and which has a system of channels, of variable section through which the cooling fluid circulates which can be it water for preparing hot water or air for heating a room, a system of channels that ensures the entry of the cooling fluid through the area in the center of the panel (1), the area with the highest temperature, and its evacuation through the area in the corner of the panel (2), the least warm area.

2. Hybrid system for improving the energy efficiency of photovoltaic panels, according to claim 1, **characterized in that** the cooling fluid enters the system of channels and is directed through radial and concentric channels over the entire surface of the panel, the section of the channels gradually increasing as the fluid moves away from the center of the panel, which causes the velocity of the fluid through the channel to decrease, which facilitates the transfer of heat to the cooling fluid even if its temperature gradually increases, obtaining a cooling of the entire surface of the photovoltaic panel and a heating of the cooling fluid , due to the optimization of heat transfer through the geometry of the channels.
